# NOUVEAU FASCICULE DE BREVET EUROPEEN

(11) **EP 2 867 831 B2**
(45) Date de publication et mention de la décision concernant l'opposition: **29.07.2026**
(45) Mention de la délivrance du brevet: 15.07.2020
(21) Numéro de dépôt: 13725722.6
(22) Date de dépôt: 03.05.2013
(51) Int. Cl.: G06K 19/077

(54) **PROCÉDÉ DE FABRICATION D'UN MICROCIRCUIT SANS CONTACT**
VERFAHREN ZUR HERSTELLUNG EINES KONTAKTLOSEN MIKROCHIPS
METHODE POUR LA FABRICATION D'UN MICROCIRCUIT SANS CONTACT

(30) Priorité: 02.07.2012 FR 1201866
(43) Date de publication de la demande: 06.05.2015
(73) Titulaire: Sealsq France, 13590 Meyreuil (FR)
(72) Inventeur: BOIRON, Ghislain, 13090 Aix-en-Provence (FR); PIC, Pierre, 13600 Ceyreste (FR)
(74) Mandataire: Marchand, André
(86) Numéro de dépôt international: PCT/FR2013/050982
(87) Numéro de publication internationale: WO 2014/006286

(56) Documents cités:
- EP-A1- 0 919 950
- WO-A1-2007/026077
- WO-A1-2014/006286
- WO-A1-2014/060659
- WO-A1-97/26621
- WO-A1-98/07191
- FR-A1- 2 992 761
- US-A1- 2008 283 615

## Description

La présente invention concerne les microcircuits ou circuits intégrés sans contact, et en particulier les microcircuits sans contact intégrés dans un objet tel qu'une carte en plastique (résine polymère).

Les microcircuits sans contact ou à champ proche NFC (Near Field Communication) ont été développés pour pouvoir réaliser des transactions avec un terminal, par couplage inductif ou par couplage de champ électrique.

Pour réaliser une communication par couplage inductif notamment, un facteur de couplage inductif suffisant doit être obtenu entre une bobine d'antenne du terminal et une bobine d'antenne connectée au microcircuit. Ce facteur de couplage dépend des tailles respectives des bobines d'antenne du terminal et du microcircuit, et de la distance et des positions relatives de ces deux bobines. Plus la bobine du microcircuit présente une taille proche de celle du terminal, plus le facteur de couplage entre les deux bobines peut être élevé.

Généralement, les bobines d'antenne des terminaux présentent des dimensions supérieures à celles d'une carte au format ISO 7816. Il est donc souhaitable que la bobine d'antenne du microcircuit soit la plus grande possible. Cependant, plus la taille de cette bobine est grande par rapport au microcircuit, plus il est difficile de réaliser une connexion entre la bobine et le microcircuit, qui soit fiable et suffisamment solide pour résister à une manipulation fréquente. Dans le cas des cartes à microcircuit sans contact, les cartes sont réalisées en résine polymère, généralement en PVC Polychlorure de vinyle), PC (polycarbonate), ou PET (Polytéréphtalate d'éthylène), et sont donc déformables. Il s'avère que des déformations répétées de la carte peuvent conduire à la rupture de la connexion entre la bobine et le microcircuit, ce qui met le microcircuit définitivement hors d'usage.

Le brevet US 5 955 723 propose de réaliser un couplage inductif entre une grande bobine formée sur la carte, et une petite bobine connectée au microcircuit. La grande bobine comporte une petite boucle ayant sensiblement les dimensions de la bobine du microcircuit. Le couplage inductif est réalisé en faisant coïncider le centre de la bobine du microcircuit avec celui de la petite boucle.

La présente invention concerne plus particulièrement la fabrication d'un module comportant un microcircuit connecté à une bobine d'antenne apte à être couplée par induction avec une bobine d'antenne formée sur un objet tel qu'une carte en résine polymère. Un tel module comprend généralement une plaquette de circuit imprimé double face sur laquelle sont formés d'un côté, sur une face avant, des plages de contact, de l'autre côté, sur une face arrière, une bobine d'antenne en forme de spirale avec plusieurs enroulements. Le microcircuit est généralement fixé sur une zone au centre de la bobine d'antenne. La connexion des plages de contact au microcircuit est généralement réalisée par l'intermédiaire de trous métallisés et de fils agencés entre le microcircuit et les trous métallisés.

Or la bobine d'antenne présente généralement un contact à l'intérieur de la spirale (dans la zone centrale de la bobine d'antenne) et un contact à l'extérieur. La connexion microcircuit au contact intérieur à la bobine d'antenne peut être effectuée simplement à l'aide d'un fil. En revanche, la connexion microcircuit au contact extérieur à la bobine d'antenne soulève des difficultés. En effet, le module comprenant le microcircuit et la plaquette sont ensuite fixés dans une cavité formée dans la carte, le microcircuit et les fils de connexion étant noyés dans une couche de résine électriquement isolante, de protection mécanique, limitée à la zone centrale de la bobine d'antenne. Le fil assurant la connexion entre le contact extérieur et le microcircuit doit accéder à une zone en dehors de la zone centrale de la bobine d'antenne et doit donc passer en dehors de la couche de résine de protection.

Généralement, la connexion entre le contact extérieur de la bobine d'antenne et le microcircuit est réalisée par l'intermédiaire de deux trous métallisés supplémentaires et d'une piste de connexion entre les trous métallisés formée sur la face de la plaquette où se trouvent les plages de contact. L'un des deux trous métallisés supplémentaires débouche à l'extérieur de la bobine d'antenne dans le contact extérieur de la bobine d'antenne, tandis que l'autre trou métallisé débouche à l'intérieur de la bobine d'antenne dans une plage de contact qui est reliée au microcircuit par un fil de connexion.

Il s'avère que la formation de tels trous métallisés augmente significativement le coût de fabrication du module sans contact. Pour supprimer les trous métallisés entre les plages de contact et le microcircuit, il est connu de former des trous dans la plaquette jusqu'à la couche de métal formant les plages de contact, de manière à rendre accessible chaque contact à partir de la face arrière de la plaquette. Un fil peut ensuite être fixé à chaque contact au fond des trous, et connecté au microcircuit. En revanche, il ne semble pas exister de solution pour supprimer le trou métallisé permettant de relier électriquement le contact extérieur de la bobine d'antenne à la face avant de la plaquette.

Il est donc souhaitable de concevoir un module associé à une bobine d'antenne sans avoir à former de tels trous métallisés dans la plaquette supportant la bobine d'antenne.

Des modes de réalisation concernent un procédé de fabrication d'un module sans contact tel qu'exposé dans le jeu de revendications joint.

Des modes de réalisation concernent également un procédé de fabrication d'une carte à microcircuit tel qu'exposé dans le jeu de revendications joint.

Des modes de réalisation concernent également un module sans contact tel qu'exposé dans le jeu de revendications joint.

Des modes de réalisation concernent également une carte à microcircuit telle qu'exposée dans le jeu de revendications joint.
la figure 1 représente une carte à microcircuit sans contact, selon un mode de réalisation,
la figure 2 est une vue en coupe transversale de la carte à microcircuit représentée sur la figure 1, selon un mode de réalisation,
les figures 3 et 4 sont des vues de faces avant et arrière d'une plaquette implantée dans la carte à microcircuit représentée sur la figure 1, selon un mode de réalisation,
la figure 5 est une vue de la face arrière d'un module sans contact formé à partir de la plaquette des figures 3 et 4, selon un mode de réalisation,
la figures 6 est une vue de la face arrière d'une plaquette, selon un autre mode de réalisation,
la figure 7 est une vue de la face arrière d'un module sans contact formé à partir de la plaquette de la figure 6,
la figure 8 est une vue de la face arrière d'une plaquette, selon un autre mode de réalisation,
la figure 9 est une vue de la face arrière d'un module sans contact formé à partir de la plaquette de la figure 8,
la figure 10 est une vue de la face arrière d'une plaquette, selon un autre mode de réalisation non compris dans l'invention revendiquée,
la figure 11 est une vue de la face arrière d'un module sans contact non compris dans l'invention revendiquée, formé à partir de la plaquette de la figure 10,
les figures 12 et 13 sont des vues de faces avant et arrière d'une plaque dans laquelle sont formées collectivement plusieurs modules sans contact, selon un mode de réalisation,
la figure 14 représente une plaque dans laquelle sont formées collectivement plusieurs cartes à microcircuit sans contact, selon un mode de réalisation.

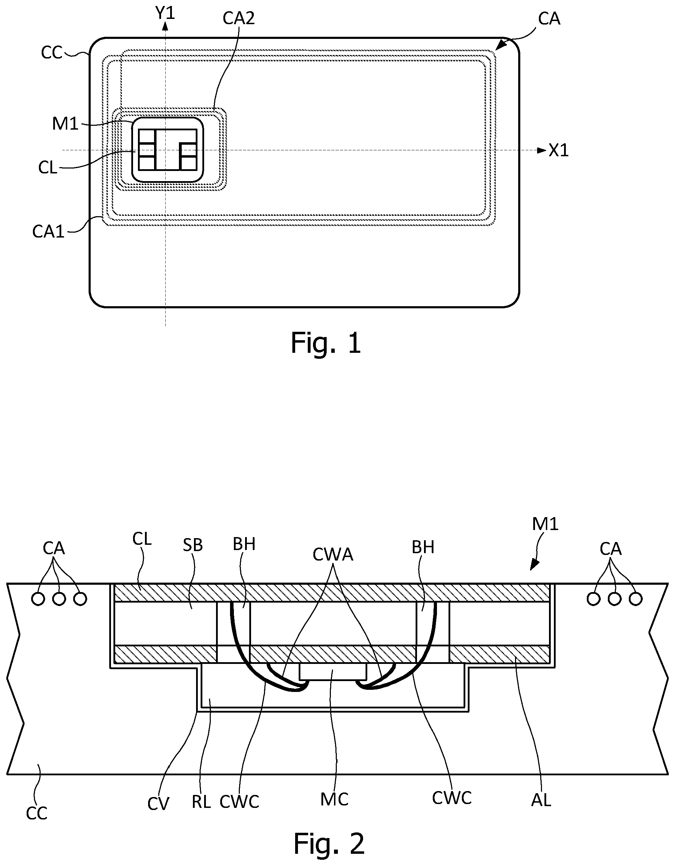

La figure 1 représente une carte à microcircuit sans contact CC comprenant une bobine d'antenne CA et un module de microcircuit M1. La bobine CA comprend plusieurs spires, par exemple de 2 à 4, et forme une grande boucle CA1 et une petite boucle CA2. La grande boucle CA1, suit le bord de la carte CA, ou seulement une partie de ce bord comme illustré par la figure 1. La grande boucle CA1 peut ainsi approcher le bord de la carte à une distance minimum pouvant atteindre 2 à 3 mm. Le module comprend une bobine d'antenne (non apparente sur la figure 1) qui peut être disposée en regard de la boucle CA2. Dans ce cas, les bobines du module et de la carte CC sont implantées dans la carte à des profondeurs différentes.

Selon un mode de réalisation, la boucle CL12 présente une forme allongée dont la longueur, suivant un axe X1, est supérieure de 20 à 50% à la largeur de la boucle, suivant un axe Y1. La largeur de la boucle CA2 est comprise entre 1 et 1,1 fois la largeur intérieure d'une bobine d'antenne du module M1, non apparente sur la figure 1. Ici, X1 et Y1 désignent les axes longitudinal et transversal de la carte CC.

La figure 2 représente en coupe transversale suivant l'axe X1, la carte CC et le module M1. La carte CC comprend une cavité CV dans laquelle est engagée le module M1. Le module M1 comprend une plaquette formée d'un substrat SB électriquement isolant, et de deux couches CL, AL électriquement conductrices recouvrant respectivement une face avant et une face arrière du substrat SB. Le module M1 comprend un microcircuit MC qui est fixé sur la face arrière de la plaquette, c'est-à-dire sur la couche AL. Le microcircuit MC est relié à des plages de contact formées dans la couche CL, par l'intermédiaire de fils CWC connectés d'un côté au microcircuit et passant dans des trous BH au travers du substrat SB pour atteindre les contacts formés dans la couche CL. Le microcircuit MC est relié à des plages de connexion d'une bobine d'antenne formée dans la couche AL, par l'intermédiaire de fils CWA connectés d'un côté au microcircuit et de l'autre à la couche AL. L'ensemble du microcircuit MC et des fils CWC, CWA est noyé dans une couche de résine RL assurant une protection mécanique de ces derniers. La couche RL s'étend seulement sur une zone centrale de la face arrière de la couche AL.

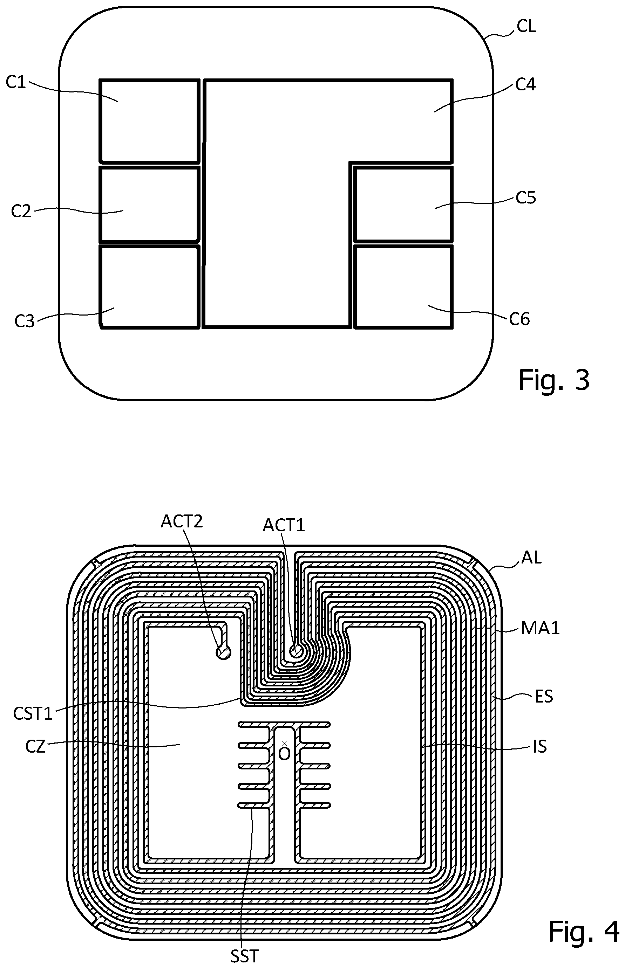

Les figures 3 et 4 sont des vues des faces avant et arrière de la plaquette SB, c'est-à-dire des couches CL et AL. Sur la figure 3, la couche CL comprend des plages de contact C1, C2, C3, C4, C5, C6, par exemple de la forme spécifiée par la norme ISO 7816.

Sur la figure 4, une bobine d'antenne MA1 est formée dans la couche AL, par exemple par gravure. La bobine d'antenne MA1 présente la forme d'une spirale comportant plusieurs spires, par exemple entre 5 et 10 spires, dont une spire extérieure ES et une spire intérieure IS. Dans l'exemple de la figure 4, la bobine MA1 comporte 8 spires. La bobine d'antenne MA1 comprend deux plages de connexion ACT1, ACT2 pour connecter la bobine d'antenne au microcircuit MC, à savoir une plage de connexion ACT1 reliée à la spire extérieure ES et située à l'extérieur de celle-ci, et une plage de connexion ACT2 reliée à la spire intérieure IS et située à l'intérieur de cette dernière.

Dans l'exemple de la figure 4, la bobine MA1 présente une forme carrée avec des angles arrondis. D'autres formes peuvent bien entendu être envisagées. Ainsi, la bobine MA1 peut ne pas avoir d'angles arrondis, ou bien être circulaire.

Selon un mode de réalisation, les deux plages de connexion ACT1, ACT2 de la bobine d'antenne MA1 sont situées dans une zone centrale CZ de la bobine d'antenne délimitée par la spire intérieure IS de la bobine MA1, sans tenir compte d'une zone de contournement CST1. Dans la zone CST1, les spires de la bobine MA1 à l'exception de la spire ES, contournent la plage de connexion ACT1, en passant entre la plage ACT1 et un point central O de la bobine MA1. La spire extérieure ES peut suivre la totalité du contour de la plaquette SB à l'exception d'une zone permettant le passage d'une piste conductrice reliant la plage de connexion ACT1 à la spire extérieure ES. La spire intérieure IS suit la totalité du contour de la zone centrale CZ à l'exception d'une partie située dans la zone de contournement CST1 où la spire contourne la plage ACT1. En d'autres termes, les plages de connexion ACT1, ACT21 sont situées dans la zone centrale CZ à une distance du contour extérieur de la bobine supérieure à la distance entre les spires ES et IS.

Selon un autre mode de réalisation, la couche AL comprend une structure de support SST pour supporter le microcircuit MC (non apparent sur la figure 4). La structure SST peut être indépendante de la bobine MA1 ou être reliée à cette dernière. Dans l'exemple de la figure 4, la structure fait partie de la spire intérieure IS de la bobine MA1 à l'opposé de la plage de connexion ACT1. La structure SST comporte une partie en forme de U avec deux branches parallèles et une base contournant le centre O de la bobine MA1, et plusieurs branches perpendiculaires aux branches de la forme en U rattachées à un bord extérieur des branches de la forme en U. Il est à noter que la structure SST pourrait être séparée de la spire intérieure de la bobine MA1.

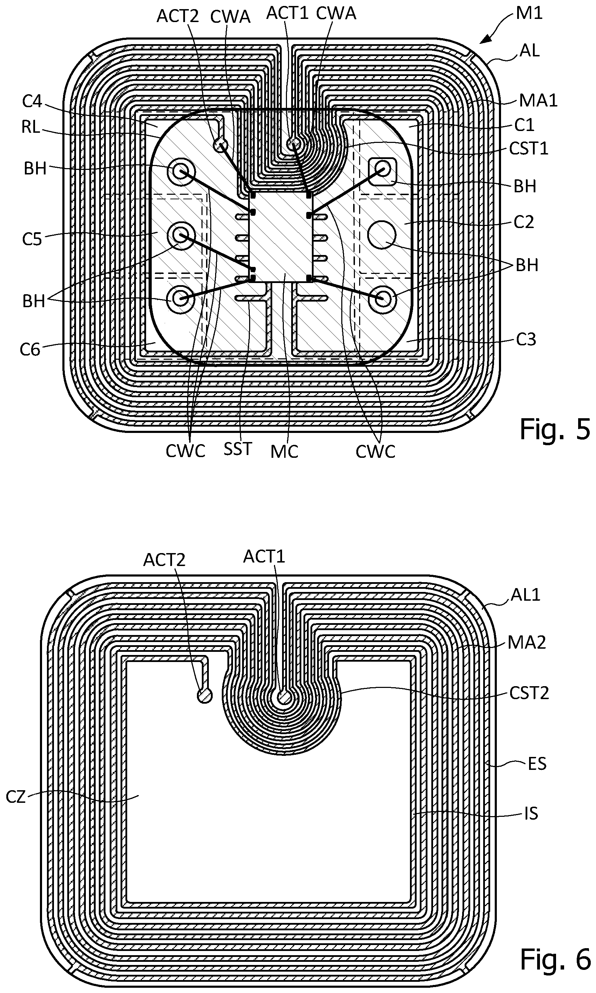

La figure 5 représente la face arrière du module M1, montrant le microcircuit MC, les fils de connexion CWA, CWC, et la couche RL de protection (zone hachurée). Sur la figure 5, le microcircuit MC repose en partie sur une partie des spires de la bobine MA1 dans la zone de contournement CST1, et en partie sur la structure de support SST. Sachant que la couche AL présente une certaine épaisseur, la structure permet de maintenir le microcircuit MC dans un plan parallèle à la face de la couche SB sur laquelle est formée la couche AL. Les fils CWC sont soudés à des plages de connexion du microcircuit MC et passent dans des trous BH au travers de la couche AL et de la plaquette SB pour atteindre les contacts C1-C6 formés dans la couche CL, auxquels ils sont soudés. Les fils CWA sont soudés à des plages de connexion du microcircuit MC et aux plages de connexion ACT1 et ACT2. La couche RL englobe le microcircuit MC et tous les fils de connexion CWC, CWA, tout en ne recouvrant qu'une partie centrale de la couche AL, entourée par sensiblement toutes les spires de la bobine MA1.

Sur les figures 4 et 5, la bobine MA1 dans la zone de contournement CST1, présente d'un côté une forme arrondie, et de l'autre, une extension anguleuse pour supporter le microcircuit MC sur toute la largeur de ce dernier.

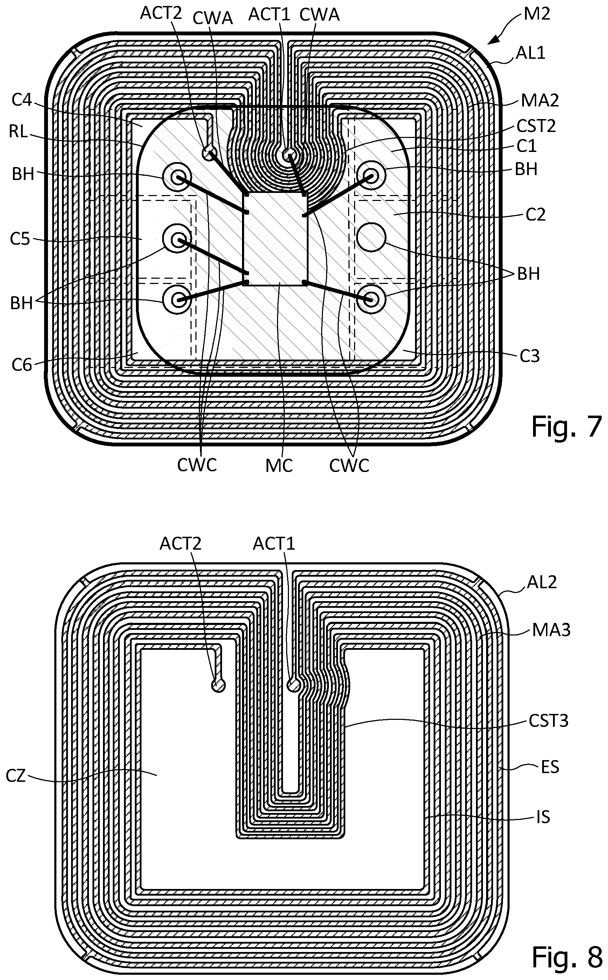

Les figures 6 et 7 représentent une couche AL1 remplaçant la couche AL et un module M2 comprenant la couche AL1. Dans certains cas, il peut ne pas être nécessaire de prévoir une structure support SST, notamment lorsqu'il est acceptable que le microcircuit ne soit pas rigoureusement disposé parallèlement à la face arrière de la plaquette SB. Ainsi, sur la figure 6, la couche AL1 diffère de la couche AL en ce qu'elle ne comporte pas de structure support SST, mais seulement une bobine MA2 avec les plages de connexion ACT1, ACT2, et une zone de contournement CST2 dans laquelle les spires de la bobine MA2 contournent la plage de connexion ACT1. Ici encore, les deux plages de connexion ACT1, ACT2 sont réalisées dans la zone centrale CZ de la bobine MA2 délimitée par la spire intérieure IS de la bobine MA2, sans tenir compte de la zone de contournement CST2. Les plages de connexion ACT1, ACT2 sont également situées à une distance du contour extérieur de la bobine supérieure à la distance entre les spires ES et IS. Dans l'exemple de la figure 6, les spires de la bobine dans la zone de contournement CST2 présentent une forme sensiblement en demi-cercle.

Le module M2 représenté sur la figure 7 diffère de celui (M1) de la figure 5 uniquement en ce que la couche AL est remplacée par la couche AL1 telle que représentée sur la figure 6. Sur la figure 7, le microcircuit MC repose en partie sur la couche AL1 formant les spires de la bobine MA2 dans la zone de contournement CST2, et en partie directement sur la plaquette SB. Une couche de colle permettant le maintien du microcircuit MC sur la plaquette, peut permettre de compenser au moins partiellement une différence éventuelle de niveau correspondant à l'épaisseur de la couche AL1.

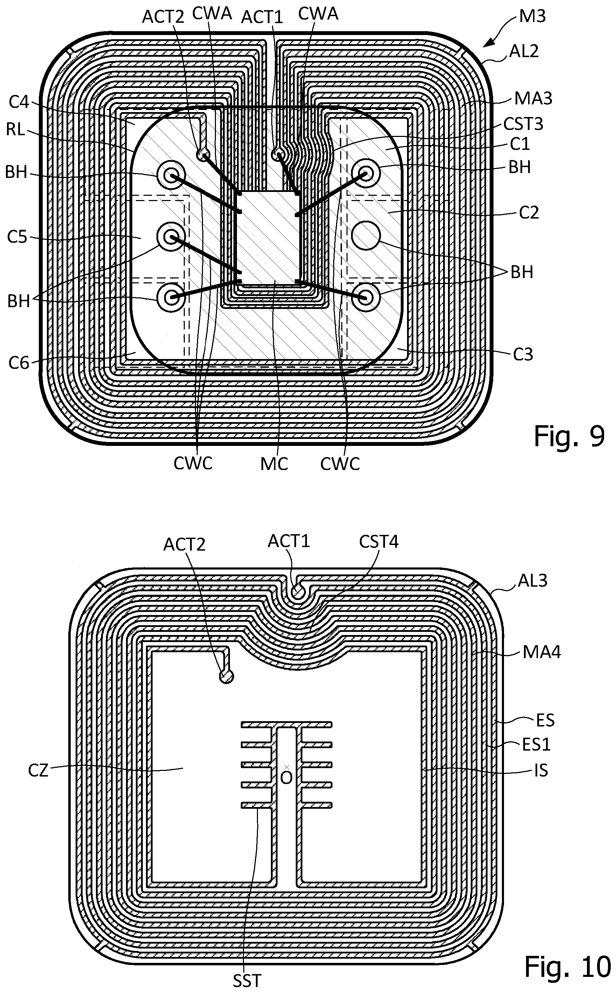

Les figures 8 et 9 représentent une couche AL2 remplaçant la couche AL et un module M3 comprenant la couche AL2. Ainsi, sur la figure 8, la couche AL2 diffère de la couche AL en ce qu'elle forme une zone de contournement CST3 de la bobine MA3. Les spires de la bobine MA3 dans la zone CST3 sont prolongées au delà du centre de la bobine pour former également une structure support supportant le microcircuit MC. Ici encore, les deux plages de connexion ACT1, ACT2 sont réalisées dans la zone centrale CZ délimitée par la spire intérieure IS de la bobine MA3, en faisant abstraction de la zone de contournement CST3.

Le module M3 représenté sur la figure 9 diffère de celui de la figure 5 uniquement en ce que la couche AL est remplacée par la couche AL2. Sur la figure 9, le microcircuit MC repose entièrement sur la zone de contournement CST3 de la bobine MA3. De cette manière, le microcircuit MC se trouve entièrement supporté par la couche AL2 et donc maintenu dans un plan parallèle à la plaquette SB.

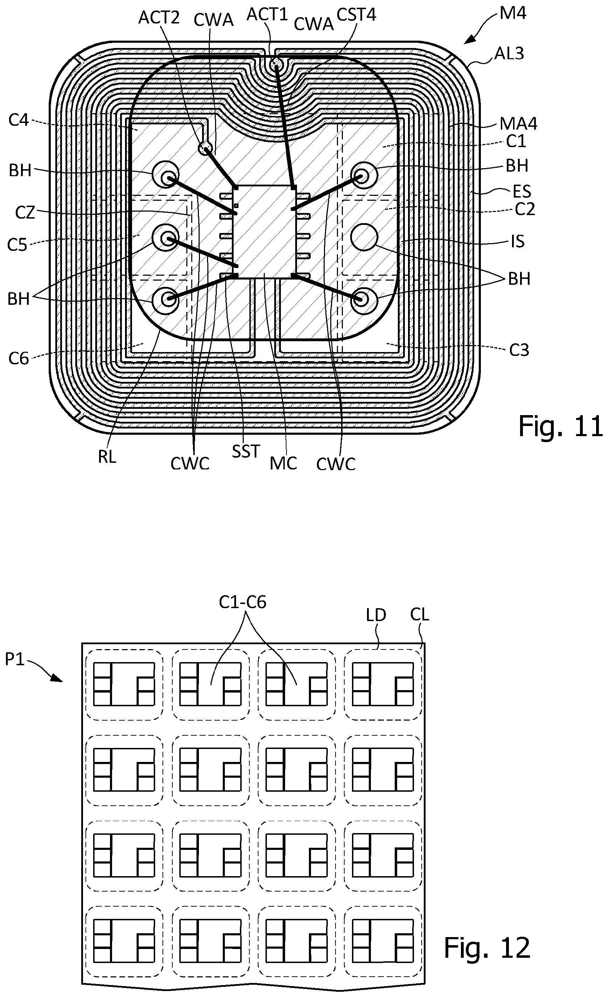

Les figures 10 et 11 représentent une couche AL3 remplaçant la couche AL et un module M4 qui n'est pas compris dans l'invention revendiquée, comprenant la couche AL3. La couche AL3 forme une bobine d'antenne MA4 qui n'est pas comprise dans l'invention revendiquée et qui diffère de la bobine MA1 en ce que la plage de connexion extérieure ACT1 est situé à l'intérieur d'un contour délimité par la spire extérieure ES de la bobine MA4, mais pas nécessairement à l'intérieur d'un contour délimité par la spire intérieure IS. En d'autres termes, la plage ACT1 est simplement située à une distance du point central O de la bobine inférieure à la distance entre la spire ES et le point O.

Dans l'exemple des figures 10 et 11, qui n'est pas compris dans l'invention revendiquée, la plage de connexion ACT1 n'est pas située à l'intérieur d'un contour délimité par la spire ES1 adjacente à la spire ES. La plage ACT1 est située à une distance du point O sensiblement égale à la distance entre le point O et la spire ES1. La bobine MA4 comprend une zone de contournement CST4 dans laquelle les spires de la bobine MA4 à l'exception de la spire ES contournent la plage de connexion ACT1. Dans l'exemple de la figure 10, les spires de la bobine MA4 dans la zone de contournement CST4 présentent une forme sensiblement en arc de cercle. Par ailleurs, couche AL3 peut comprendre la structure support SST pour supporter le microcircuit MC. Dans l'exemple de la figure 10, la structure SST est reliée à la spire intérieure IS.

Le module M4 représenté sur la figure 11 diffère de celui (M1) de la figure 5 uniquement en ce que la couche AL est remplacée par la couche AL3 telle que représentée sur la figure 10. Sur la figure 11, le microcircuit MC repose sur la structure support SST formée dans la couche AL3. Pour protéger le fil de connexion CWA entre le microcircuit MC et la plage ACT1, la couche de protection RL n'est pas disposée uniquement sur la zone centrale CZ, mais s'étend à proximité d'un bord du module M4 sur la plage ACT1.

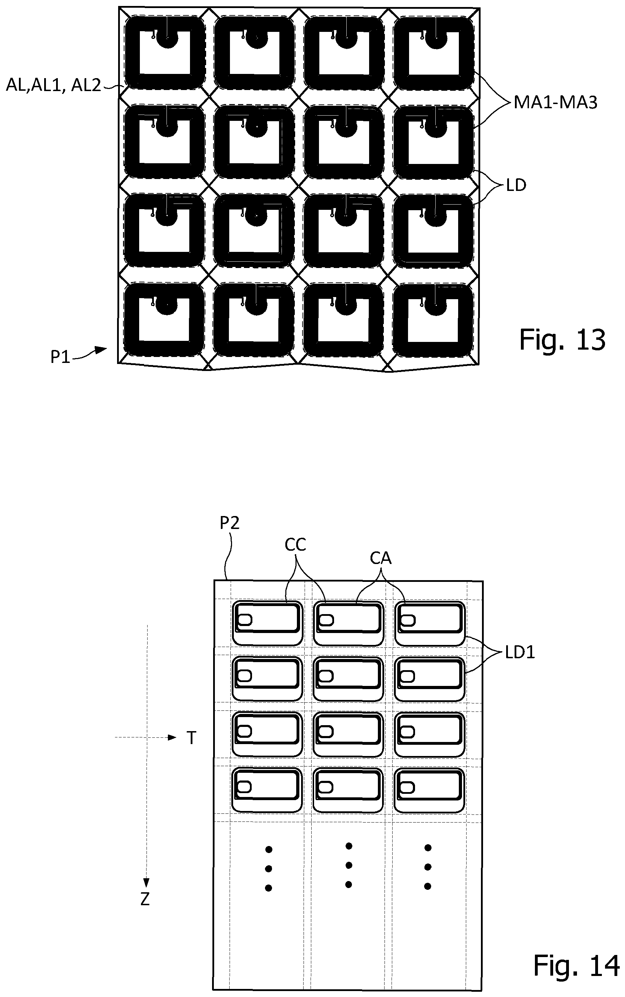

Selon un mode de réalisation, les modules M1, M2, M3 ou M4 sont réalisés collectivement par gravure d'une plaque couverte sur chaque face d'une couche électriquement conductrice, par exemple une couche en cuivre. La plaque peut être une plaque de circuit imprimé double face. Les figures 12 et 13 représentent les faces avant et arrière d'une partie de la plaque P1 après gravure de ses deux faces. Sur la figure 12, la plaque P1 comprend plusieurs ensembles de plages de contact C1-C6, par exemple conformes à la norme ISO 7816. Les ensembles de plages de contact C1-C6 sont répartis sur la plaque P1 en rangées et en colonnes. Sur la figure 13, plusieurs bobines MA1-MA3 de module sont formées sur la face arrière de la plaque P1, chaque bobine étant formée en regard d'un ensemble de plages de contact C1-C6.

A une étape suivante, la plaque P1 peut être percée à partir de la face arrière (côté bobines MA1-MA3) pour former les trous BH jusqu'à la couche CL, dans la zone centrale CZ de chaque bobine. A une étape suivante, un microcircuit MC peut être placé au centre de chaque bobine MA1-MA3, puis connecté à l'aide de fils aux plages de contacts C1-C6 et aux plages de connexion ACT1, ACT2 de la bobine. La couche de résine RL peut ensuite être formée pour protéger chaque microcircuit avec ses fils de connexion. A cet effet, l'ensemble de la face arrière de la plaque P1 peut être couverte d'une couche de résine puis gravée pour dégager sensiblement toutes les spires des bobines MA1-MA3. Alternativement, la couche de résine sur chaque microcircuit peut être moulée à l'aide d'un moule présentant des orifices ayant les dimensions souhaitées, en regard de chaque microcircuit MC fixé sur la plaque P1. Les modules M1-M3 peuvent ensuite être individualisés par découpage de la plaque P1 suivant des lignes de découpe LD.

La plaque P1 peut également être percée pour former les trous BH avant qu'elle soit recouverte des couches CL et AL, AL1 ou AL2.

Selon un mode de réalisation, la carte CC est fabriquée collectivement dans des plaques en résine polymère (PVC, PC ou PET). Ainsi, la figure 14 représente une plaque P2 dans laquelle sont formées collectivement des bobines d'antenne CA de carte. Dans l'exemple de la figure 13, les axes longitudinaux des cartes sont parallèles à un axe transversal T de la plaque P2. Les axes longitudinaux des cartes CC peuvent également être parallèle à un axe longitudinal Z de la plaque P2. Les bobines CA peuvent être réalisées collectivement à l'aide d'un fil isolé dans une gaine ou par un verni, qui est enfoncé progressivement dans la carte à l'aide d'ultrasons aptes à faire fondre localement la carte. Le fil isolé est ainsi déroulé en suivant le trajet du fil formant les spires de la bobine à former. Le fil peut présenter un diamètre 50 à 150 µm. Le pas d'espacement entre les spires peut être de 150 à 500 µm. Les cartes sont ensuite individualisées par découpe de la plaque P2 suivant des lignes de découpe LD1. Les modules M1-M3 sont ensuite insérés dans les cartes CC individualisées. A cet effet, une cavité est formée dans chaque carte, en un emplacement repéré précisément par rapport aux bords de la carte, et un module M1-M3 est introduit et fixé dans chaque cavité.

Il apparaîtra clairement à l'homme de l'art que la présente invention est susceptible de diverses variantes de réalisation et diverses applications. En particulier, l'invention n'est pas limitée à un module à deux interfaces de communication à contacts et sans contact, mais peut également s'appliquer à un module ne comportant qu'une interface de communication comportant seulement une bobine d'antenne. L'invention n'est pas non plus limitée aux cartes ayant le format défini par la norme ISO 7816, ou à des contacts C1-C6 conformes à cette norme.

Par ailleurs, la couche de protection RL peut ne pas être nécessaire, ou être formée lorsque le module est inséré dans une cavité formée dans une carte.

## Revendications

1. Procédé de fabrication d'un module sans contact comprenant une bobine d'antenne de microcircuit sans contact, comprenant des étapes consistant à :
déposer une première couche électriquement conductrice (AL, AL1, AL2) sur une première face d'une plaquette (SB),
former dans la première couche une bobine d'antenne (MA1-MA3) en spirale comportant plusieurs spires, comprenant une spire intérieure (IS) reliée à une plage de connexion (ACT2) intérieure à la spire intérieure et une spire extérieure (ES) reliée à une plage de connexion (ACT1) extérieure à la spire extérieure,
fixer un microcircuit (MC) sur la première face de la plaquette (SB), dans une zone centrale (CZ) de la bobine d'antenne (MA1- MA3), et
relier des plages de connexion du microcircuit aux plages de connexion (ACT1, ACT2) de la bobine d'antenne, par l'intermédiaire de fils (CWA),
**caractérisé en ce que** :
la spire extérieure (ES) suit la totalité du contour de bobine d'antenne à l'exception d'une zone permettant le passage d'une piste conductrice reliant la plage de connexion extérieure (ACT1) à la spire extérieure, les plages de connexion extérieure et intérieure (ACT1, ACT2) de la bobine d'antenne (MA1-MA3) étant formées dans la zone centrale (CZ) de la bobine d'antenne, la bobine d'antenne comprenant une zone de contournement (CST1-CST3) dans laquelle chaque spire contourne la plage de connexion extérieure (ACT1) par la zone centrale, la zone centrale (CZ) de la bobine d'antenne (MA1- MA3) étant délimitée par la spire intérieure (IS) de la bobine d'antenne sans tenir compte de la zone de contournement.

2. Procédé selon la revendication 1, dans lequel la zone de contournement (CST1, CST3) de la bobine d'antenne (MA1, MA3) est conformée pour supporter le microcircuit (MC) sur toute la largeur et au moins partiellement la longueur de ce dernier.

3. Procédé selon l'une des revendications 1 et 2, dans lequel la couche (AL) comporte une structure support (SST) pour supporter le microcircuit (MC), la structure support (SST) pouvant être reliée à la spire intérieure (IS) de la bobine d'antenne (MA1).

4. Procédé selon l'une des revendications 1 à 3, comprenant des étapes consistant à :
déposer une seconde couche électriquement conductrice (CL) sur une seconde face de la plaquette (SB),
former dans la seconde couche des plages de connexion (C1-C6), et
former des trous (BH) dans la plaquette à partir de la première couche (AL, AL1, AL2), jusqu'à atteindre les plages de connexion de la seconde couche.

5. Procédé selon l'une des revendications 1 à 4, comprenant des étapes consistant à :
déposer une seconde couche électriquement conductrice (CL) sur une seconde face de la plaquette (SB),
former dans la seconde couche des plages de connexion (C1-C6), et
former des trous (BH) dans la plaquette (SB) à partir de la première couche (AL, AL1, AL2), jusqu'à atteindre les plages de connexion (C1-C6) de la seconde couche (CL), et
relier des plages de connexion du microcircuit (MC) aux plages de connexion de la seconde couche (CL) par l'intermédiaire de fils (CWC) passant dans les trous (BH).

6. Procédé selon l'une des revendications 1 à 5, comprenant une étape de dépôt d'une couche de protection électriquement isolante (RL) sur le microcircuit (MC) et les fils de connexion (CWA, CWC).

7. Procédé selon l'une des revendications 1 à 6, dans lequel la plaquette (SB) appartient à une plaque (P1) dans laquelle sont formés collectivement plusieurs modules sans contact (M1-M3), le procédé comprenant une étape de découpe de la plaque pour individualiser les modules, effectuée après connexion de chaque microcircuit (MC).

8. Procédé de fabrication d'une carte à microcircuit comprenant des étapes consistant à :
exécuter le procédé selon l'une des revendications 1 à 7, pour obtenir un module sans contact (M1-M3),
former une bobine d'antenne (CA) dans une carte (CC), et
implanter le module dans la carte, la bobine d'antenne de la carte présentant une partie proche de la bobine d'antenne du microcircuit (MA1-MA3) pour établir un couplage par induction entre les deux bobines d'antenne.

9. Procédé selon la revendication 8, dans lequel la carte appartient à une plaque (P2) dans laquelle sont formés collectivement des cartes à microcircuit sans contact (MC), le procédé comprenant une étape de découpe de la plaque pour individualiser les cartes, effectuée après formation des bobines d'antenne de carte (CC) dans la plaque, et avant implantation d'un exemplaire du module (M1-M3) dans chaque carte.

10. Module sans contact comprenant une bobine d'antenne de microcircuit sans contact, le module comprenant :
une plaquette (SB) recouverte sur une première face d'une première couche (AL, AL1, AL2) dans laquelle est formée une bobine d'antenne (MA1-MA3), la bobine d'antenne comprenant plusieurs spires en spirale, dont une spire intérieure (IS) reliée à une plage de connexion (ACT2) intérieure à la spire intérieure et une spire extérieure (ES) reliée à une plage de connexion (ACT1) extérieure à la spire extérieure,
un microcircuit (MC) fixé sur la première face de la plaquette (SB) dans une zone centrale (CZ) de la bobine d'antenne (MA1- MA3) et comportant des plages de connexion (ACT1, ACT2) reliées aux plages de connexion de la bobine d'antenne par l'intermédiaire de fils (CWA),
**caractérisé en ce que**
la spire extérieure (ES) suit la totalité du contour de bobine d'antenne à l'exception d'une zone permettant le passage d'une piste conductrice reliant la plage de connexion extérieure (ACT1) à la spire extérieure, les plages de connexion extérieure et intérieure (ACT1, ACT2) de la bobine d'antenne (MA1-MA3) étant formées dans la zone centrale (CZ) de la bobine d'antenne, la bobine d'antenne comprenant une zone de contournement (CST1-CST3) dans laquelle chaque spire contourne la plage de connexion extérieure, la zone centrale (CZ) de la bobine d'antenne (MA1- MA3) étant délimitée par la spire intérieure (IS) de la bobine d'antenne sans tenir compte de la zone de contournement.

11. Module sans contact selon la revendication 10, dans lequel les spires dans la zone de contournement (CST1, CST3) sont conformées pour supporter le microcircuit (MC) sur toute la largeur et au moins partiellement sur la longueur de ce dernier.

12. Module sans contact selon l'une des revendications 10 et 11, dans lequel la première couche (AL) comporte une structure support (SST) pour supporter le microcircuit (MC), la structure support pouvant être reliée à la spire intérieure (IS) de la bobine d'antenne (MA1).

13. Module sans contact selon l'une des revendications 10 à 12, comprenant :
une seconde couche (CL) électriquement conductrice recouvrant une seconde face de la plaquette (SB), la seconde couche formant des plages de connexion (C1-C6),
des trous (BH) traversant la plaquette (SB) à partir de la première face, jusqu'à atteindre les plages de connexion de la seconde couche.

14. Module sans contact selon la revendication 10, comprenant une seconde couche (CL) électriquement conductrice recouvrant une seconde face de la plaquette (SB), la seconde couche formant des plages de connexion (C1-C6), et des fils reliant des plages de connexion du microcircuit (MC) aux plages de connexion de la seconde couche, en passant dans des trous (BH) formés dans la plaquette à partir de la première couche (AL, AL1, AL2), et atteignant les plages de connexion de la seconde couche.

15. Module sans contact selon l'une des revendications 10 à 14, comprenant une couche de protection électriquement isolante recouvrant le microcircuit et les fils de connexion (CWA, CWC).

16. Carte à microcircuit comprenant une bobine d'antenne (CA) et un module (M1-M3) selon l'une des revendications 10 à 15, la bobine d'antenne de la carte (CC) présentant une partie proche de la bobine d'antenne du module, pour établir un couplage par induction entre les deux bobines d'antenne.

## Patentansprüche

1. Verfahren zum Herstellen eines kontaktlosen Moduls, umfassend eine Antennenspule einer kontaktlosen Mikroschaltung, umfassend Schritte, bestehend aus:
Abscheiden einer ersten elektrisch leitfähigen Schicht (AL, AL1, AL2) auf eine erste Seite eines Wafers (SB),
Ausbilden in der ersten Schicht einer spiralförmigen Antennenspule (MA1 - MA3), die mehrere Windungen aufweist, umfassend eine innere Windung (IS), die mit einer Anschlussfläche (ACT2) innerhalb der inneren Windung verbunden ist, und eine äußere Windung (ES), die mit einer Anschlussfläche (ACT1) außerhalb der äußeren Windung verbunden ist,
Befestigen einer Mikroschaltung (MC) auf der ersten Seite des Wafers (SB) in einem zentralen Bereich (CZ) der Antennenspule (MA1-MA3), und
Verbinden von Anschlussflächen der Mikroschaltung mit den Anschlussflächen (ACT1, ACT2) der Antennenspule über Drähte (CWA),
**dadurch gekennzeichnet, dass:**
die äußere Windung (ES) der gesamten Kontur der Antennenspule mit Ausnahme eines Bereichs folgt, der den Durchgang einer Leiterbahn ermöglicht, die die äußere Anschlussfläche (ACT1) mit der äußeren Windung verbindet, wobei die äußere und die innere Anschlussfläche (ACT1, ACT2) der Antennenspule (MA1-MA3) in dem zentralen Bereich (CZ) der Antennenspule ausgebildet sind, die Antennenspule umfassend einen Umgehungsbereich (CST1-CST3), in dem jede Windung die äußere Anschlussfläche (ACT1) durch den zentralen Bereich umgeht, wobei der zentrale Bereich (CZ) der Antennenspule (MA1-MA3) durch die innere Windung (IS) der Antennenspule ohne Berücksichtigung des Umgehungsbereichs begrenzt ist.

2. Verfahren nach Anspruch 1, wobei der Umgehungsbereich (CST1, CST3) der Antennenspule (MA1, MA3) zum Tragen der Mikroschaltung (MC) über ihre gesamte Breite und mindestens teilweise die Länge dieser letzteren angepasst ist.

3. Verfahren nach einem der Ansprüche 1 und 2, wobei die Schicht (AL) eine Trägerstruktur (SST) zum Tragen der Mikroschaltung (MC) aufweist, wobei die Trägerstruktur (SST) mit der inneren Windung (IS) der Antennenspule (MA1) verbunden werden kann.

4. Verfahren nach einem der Ansprüche 1 bis 3, umfassend die Schritte, bestehend aus:
Abscheiden einer zweiten elektrisch leitfähigen Schicht (CL) auf eine zweite Seite des Wafers (SB),
Ausbilden in der zweiten Schicht von Anschlussflächen (C1-C6), und
Ausbilden von Löchern (BH) in dem Wafer ausgehend von der ersten Schicht (AL, AL1, AL2) bis zu einem Erreichen der Anschlussflächen der zweiten Schicht.

5. Verfahren nach einem der Ansprüche 1 bis 4, umfassend die Schritte, bestehend aus:
Abscheiden einer zweiten elektrisch leitfähigen Schicht (CL) auf eine zweite Seite des Wafers (SB),
Ausbilden in der zweiten Schicht von Anschlussflächen (C1-C6), und
Ausbilden von Löchern (BH) in dem Wafer (SB) ausgehend von der ersten Schicht (AL, AL1, AL2) bis zu dem Erreichen der Anschlussflächen (C1-C6) der zweiten Schicht (CL), und
Verbinden von Anschlussflächen der Mikroschaltung (MC) mit den Anschlussflächen der zweiten Schicht (CL) über Drähte (CWC), die durch die Löcher (B) verlaufen.

6. Verfahren nach einem der Ansprüche 1 bis 5, umfassend einen Schritt zum Abscheiden einer elektrisch isolierenden Schutzschicht (RL) auf die Mikroschaltung (MC) und die Verbindungsdrähte (CWA, CWC).

7. Verfahren nach einem der Ansprüche 1 bis 6, wobei der Wafer (SB) zu einer Platte (P1) gehört, auf der mehrere kontaktlose Module (M1-M3) gemeinsam ausgebildet sind, das Verfahren umfassend einen Schritt zum Zerschneiden der Platte zum Vereinzeln der Module, der nach dem Anschließen jeder Mikroschaltung (MC) ausgeführt wird.

8. Verfahren zum Herstellen einer Mikroschaltungskarte, umfassend die Schritte, bestehend aus:
Ausführen des Verfahrens nach einem der Ansprüche 1 bis 7 zum Erhalten eines kontaktlosen Moduls (M1-M3),
Ausbilden einer Antennenspule (CA) in einer Karte (CC) und
Einsetzen des Moduls in die Karte, wobei die Antennenspule der Karte einen nahen Teil der Antennenspule der Mikroschaltung (MA-M3) zum Aufbauen einer Kopplung durch Induktion zwischen den zwei Antennenspulen vorweist.

9. Verfahren nach Anspruch 8, wobei die Karte zu einer Platte (P2) gehört, in der kontaktlose Mikrochipkarten (MC) gemeinsam ausgebildet sind, das Verfahren umfassend einen Schritt des Zerschneidens der Platte zum Vereinzeln der Karten, der nach dem Ausbilden der Kartenantennenspulen (CC) in der Platte und vor dem Einsetzen eines Exemplars des Moduls (M1-M3) in jede Karte durchgeführt wird.

10. Kontaktloses Modul, umfassend eine Antennenspule einer kontaktlosen Mikroschaltung, das Modul umfassend:
einen Wafer (SB), der auf einer ersten Seite mit einer ersten Schicht (AL, AL1, AL2) bedeckt ist, in der eine Antennenspule (MA1-MA3) ausgebildet ist, die Antennenspule umfassend mehrere spiralförmige Windungen, von denen eine innere Windung (IS) mit einer Anschlussfläche (ACT2) innerhalb der inneren Windung verbunden ist und eine äußere Windung (ES) mit einer Anschlussfläche (ACT1) außerhalb der äußeren Windung verbunden ist,
eine Mikroschaltung (MC), die auf der ersten Seite des Wafers (SB) in einem zentralen Bereich (CZ) der Antennenspule (MA1-MA3) befestigt ist und Anschlussflächen (ACT1, ACT2) aufweist, die über Drähte (CWA) mit Anschlussflächen der Antennenspule verbunden sind,
**dadurch gekennzeichnet, dass**
die äußere Windung (ES) der gesamten Kontur der Antennenspule mit Ausnahme eines Bereichs folgt, der den Durchgang einer Leiterbahn ermöglicht, die die äußere Anschlussfläche (ACT1) mit der äußeren Windung verbindet, wobei die äußere und die innere Anschlussfläche (ACT1, ACT2) der Antennenspule (MA1-MA3) in dem zentralen Bereich (CZ) der Antennenspule ausgebildet sind, die Antennenspule umfassend einen Umgehungsbereich (CST1-CST3), in dem jede Windung die äußere Anschlussfläche umgeht, wobei der zentrale Bereich (CZ) der Antennenspule (MA1-MA3) durch die innere Windung (IS) der Antennenspule ohne Berücksichtigung des Umgehungsbereichs begrenzt ist.

11. Kontaktloses Modul nach Anspruch 10, wobei die Windungen in dem Umgehungsbereich (CST1, CST3) zum Tragen der Mikroschaltung (MC) über die gesamte Breite und mindestens teilweise über die Länge dieser letzteren angepasst sind.

12. Kontaktloses Modul nach einem der Ansprüche 10 und 11, wobei die erste Schicht (AL) eine Trägerstruktur (SST) zum Tragen der Mikroschaltung (MC) aufweist, wobei die Trägerstruktur mit der inneren Windung (IS) der Antennenspule (MA1) verbunden werden kann.

13. Kontaktloses Modul nach einem der Ansprüche 10 bis 12, umfassend:
eine zweite elektrisch leitfähige Schicht (CL), die eine zweite Seite des Wafers (SB) bedeckt, wobei die zweite Schicht Anschlussflächen (C1-C6) ausbildet,
Löcher (BH), die ausgehend von der ersten Seite den Wafer (SB) durchqueren, bis sie die Anschlussflächen der zweiten Schicht erreichen.

14. Kontaktloses Modul nach Anspruch 10, umfassend eine zweite elektrisch leitfähige Schicht (CL), die eine zweite Seite des Wafers (SB) bedeckt, wobei die zweite Schicht Anschlussflächen (C1-C6) ausbildet, und Drähte, die Anschlussflächen der Mikroschaltung (MC) mit den Anschlussflächen der zweiten Schicht verbinden, wobei sie durch Löcher (BH) verlaufen, die in dem Wafer ausgehend von der ersten Schicht (AL, AL1, AL2) ausgebildet sind, und die Anschlussflächen der zweiten Schicht erreichen.

15. Kontaktloses Modul nach einem der Ansprüche 10 bis 14, umfassend eine elektrisch isolierende Schutzschicht, die die Mikroschaltung und die Verbindungsdrähte (CW, CWC) bedeckt.

16. Mikroschaltungskarte, umfassend eine Antennenspule (CA) und ein Modul (M1-M3) nach einem der Ansprüche 10 bis 15, wobei die Antennenspule der Karte (CC) einen nahen Teil der Antennenspule des Moduls zum Aufbauen einer Kopplung durch Induktion zwischen den zwei Antennenspulen vorweist.

## Claims

1. Method for producing a contactless module comprising a contactless microcircuit antenna coil, comprising steps consisting of:
depositing an electrically conductive first layer (AL, AL1, AL2) on a first face of a wafer (SB),
forming, in the first layer, a spiral antenna coil (MA1-MA3) with multiple turns, comprising an inner turn (IS) connected to a contact pad (ACT2) inside the inner turn and an outer turn (ES) connected to a contact pad (ACT1) outside the outer turn,
attaching a microcircuit (MC) to the first face of the wafer (SB), in a central zone (CZ) of the antenna coil (MA1-MA3), and
connecting microcircuit contact pads to the antenna coil contact pads (ACT1, ACT2) via wires (CWA),
**characterized in that:**
the outer turn (ES) follows the entire contour of the antenna coil, with the exception of a zone allowing the passage of a conductor track connecting the outer contact pad (ACT1) to the outer turn, the outer and inner contact pads (ACT1, ACT2) of the antenna coil (MA1-MA3) being formed in the central zone (CZ) of the antenna coil, the antenna coil comprising a bypass zone (CST1-CST3) in which each turn bypasses the outer contact pad (ACT1) via the central zone, the central zone (CZ) of the antenna coil (MA1-MA3) being delimited by the inner turn (IS) of the antenna coil without taking the bypass zone into account.

2. Method according to claim 1, wherein the bypass zone (CST1, CST3) of the antenna coil (MA1, MA3) is shaped to support the microcircuit (MC) over its entire width and at least partially along its length.

3. Method according to one of claims 1 and 2, wherein the layer (AL) has a support structure (SST) for supporting the microcircuit (MC), the support structure (SST) being connectable to the inner turn (IS) of the antenna coil (MA1).

4. Method according to any of claims 1 to 3, comprising steps consisting of:
depositing an electrically conductive second layer (CL) on a second face of the wafer (SB),
forming contact pads (C1-C6) in the second layer, and
forming holes (BH) in the wafer from the first layer (AL, AL1, AL2) up to the contact pads of the second layer.

5. Method according to any of claims 1 to 4, comprising steps consisting of:
depositing an electrically conductive second layer (CL) on a second face of the wafer (SB),
forming contact pads (C1-C6) in the second layer, and
forming holes (BH) in the wafer (SB) from the first layer (AL, AL1, AL2) up to the contact pads (C1-C6) of the second layer (CL), and
connecting contact pads of the microcircuit (MC) to the contact pads of the second layer (CL) via wires (CWC) that pass through the holes (BH).

6. Method according to any of claims 1 to 5, comprising a step of depositing an electrically insulating protective layer (RL) on the microcircuit (MC) and the connection wires (CWA, CWC).

7. Method according to any of claims 1 to 6, wherein the wafer (SB) belongs to a board (P1) in which multiple contactless modules (M1-M3) are collectively formed, the method comprising a step of cutting the board to individualize the modules, carried out after the connection of each microcircuit (MC).

8. Method for producing a microcircuit card comprising steps consisting of:
carrying out the method according to any of claims 1 to 7 to obtain a contactless module (M1-M3),
forming an antenna coil (CA) in a card (CC), and
implanting the module into the card, the antenna coil of the card having a part close to the antenna coil of the microcircuit (MA1-MA3) in order to establish an inductive coupling between the two antenna coils.

9. Method according to claim 8, wherein the card belongs to a board (P2) in which cards having a contactless microcircuit (MC) are collectively formed, the method comprising a step of cutting the board to individualize the cards, carried out after the formation of the antenna coils of the card (CC) in the board, and before implantation of a copy of the module (M1-M3) into each card.

10. Contactless module comprising a contactless microcircuit antenna coil, the module comprising:
a wafer (SB) covered on a first face with a first layer (AL, AL1, AL2) in which an antenna coil (MA1-MA3) is formed, the antenna coil comprising multiple spiral turns, including an inner turn (IS) connected to a contact pad (ACT2) inside the inner turn and an outer turn (ES) connected to a contact pad (ACT1) outside the outer turn,
a microcircuit (MC) attached to the first face of the wafer (SB) in a central zone (CZ) of the antenna coil (MA1-MA3) and comprising contact pads (ACT1, ACT2) connected to the antenna coil contact pads via wires (CWA),
**characterized in that**
the outer turn (ES) follows the entire contour of the antenna coil, with the exception of a zone allowing the passage of a conductor track connecting the outer contact pad (ACT1) to the outer turn, the outer and inner contact pads (ACT1, ACT2) of the antenna coil (MA1-MA3) being formed in the central zone (CZ) of the antenna coil, the antenna coil comprising a bypass zone (CST1-CST3) in which each turn bypasses the outer contact pad, the central zone (CZ) of the antenna coil (MA1-MA3) being delimited by the inner turn (IS) of the antenna coil without taking the bypass zone into account.

11. Contactless module according to claim 10, wherein the turns in the bypass zone (CST1, CST3) are shaped to support the microcircuit (MC) over its entire width and at least partially along its length.

12. Contactless module according to one of claims 10 and 11, wherein the first layer (AL) comprises a support structure (SST) for supporting the microcircuit (MC), the support structure being connectable to the inner turn (IS) of the antenna coil (MA1).

13. Contactless module according to any of claims 10 to 12, comprising:
an electrically conductive second layer (CL) covering a second face of the wafer (SB), the second layer forming contact pads (C1-C6),
holes (BH) passing through the wafer (SB) from the first face up to the contact pads of the second layer.

14. Contactless module according to claim 10, comprising an electrically conductive second layer (CL) covering a second face of the wafer (SB), the second layer forming contact pads (C1-C6), and wires connecting contact pads of the microcircuit (MC) to the contact pads of the second layer, passing through holes (BH) formed in the wafer from the first layer (AL, AL1, AL2), and reaching the contact pads of the second layer.

15. Contactless module according to any of claims 10 to 14, comprising an electrically insulating protective layer covering the microcircuit and the connection wires (CWA, CWC).

16. Microcircuit card comprising an antenna coil (CA) and a module (M1-M3) according to any of claims 10 to 15, the antenna coil of the card (CC) having a part close to the antenna coil of the module in order to establish an inductive coupling between the two antenna coils.
